(19) Europäisches Patentamt
European Patent Office
Office européen des brevets

(11) **EP 2 339 900 A2**

(12) **EUROPÄISCHE PATENTANMELDUNG**

(43) Veröffentlichungstag:
**29.06.2011 Patentblatt 2011/26**

(51) Int Cl.:
***H05K 1/02*** (2006.01)   ***H05K 1/05*** (2006.01)

(21) Anmeldenummer: **10193543.5**

(22) Anmeldetag: **02.12.2010**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **22.12.2009   DE 102009060781**

(71) Anmelder: **Automotive Lighting Reutlingen GmbH 72762 Reutlingen (DE)**

(72) Erfinder:
• **Gottheil, Martin**
  **72127 Kusterdingen (DE)**
• **Hiegler, Michael**
  **72760 Reutlingen (DE)**

(74) Vertreter: **Dreiss Patentanwälte Gerokstrasse 1 70188 Stuttgart (DE)**

(54) **Lichtmodul für eine Beleuchtungseinrichtung eines Kraftfahrzeugs sowie Beleuchtungseinrichtung mit einem solchen Lichtmodul**

(57)     Die Erfindung betrifft ein Lichtmodul (5; 6) für eine Beleuchtungseinrichtung (1) eines Kraftfahrzeugs. Das Lichtmodul (5; 6) umfasst mindestens eine Halbleiterlichtquelle (16). Um bei dem Lichtmodul (5; 6) die Abschirmung von durch den Betrieb und die Ansteuerung der Halbleiterlichtquellen (16) entstehenden Störsignalen auf einfache und kostengünstige Weise zu verbessern, wird vorgeschlagen, dass das Lichtmodul (5; 6) aufweist:

- eine metallische Grundfläche (11),
- mindestens eine auf der metallischen Grundfläche (11) ausgebildete elektrische Isolationsschicht (12),
- mindestens eine in der mindestens einen elektrischen Isolationsschicht (12) ausgebildete Aussparung (13), und
- die in der mindestens einen Aussparung (13) angeordnete mindestens eine Halbleiterlichtquelle (16).

Fig. 2a

EP 2 339 900 A2

**Beschreibung**

Die vorliegende Erfindung betrifft ein Lichtmodul für eine Beleuchtungseinrichtung eines Kraftfahrzeugs, wobei das Lichtmodul mindestens eine Halbleiterlichtquelle umfasst.

Die Erfindung betrifft außerdem eine Beleuchtungseinrichtung eines Kraftfahrzeugs, umfassend mindestens ein solches Lichtmodul.

Die Beleuchtungseinrichtung kann als ein Kraftfahrzeugscheinwerfer oder als eine beliebige Kraftfahrzeugleuchte ausgebildet sein. Während bisher Kraftfahrzeugscheinwerfer und Kraftfahrzeugleuchten üblicherweise herkömmliche Glühlampen oder Gasentladungslampen als Lichtquellen hatten, wird in Zukunft der Einsatz von Halbleiterlichtquellen (z.B. Leuchtdioden, LEDs) als Lichtquellen zunehmen. In Zukunft werden zudem Kraftfahrzeugbeleuchtungseinrichtungen mit LEDs Einsatz finden, die aus vielen einzelnen LEDs bestehen und nicht mehr nur eine eindimensionale Anordnung aufweisen. Bei diesen Beleuchtungseinrichtungen mit komplexen, mehrdimensional angeordneten Leuchtdioden (LEDs) kann durch Aus- und Einschalten einzelner LEDs die Lichtverteilung variiert werden. Scheinwerfer mit derart komplex angeordneten und einzeln ansteuerbaren LEDs werden auch als Pixel- oder Matrixscheinwerfer bezeichnet. Durch die Anhäufung mehrerer LED-Lichtquellen in einer einzigen Beleuchtungseinrichtung stellen sich neue Herausforderungen bezüglich Aufbau und Ansteuerung der LEDs. Ein sog. LED-Submount umfasst eine oder mehrere LEDs bzw. LED-Chips.

Die Leistung der einzelnen LED-Lichtquellen beziehungsweise der einzelnen LED-Chips kann über die Höhe des Betriebsstroms gesteuert werden. Außerdem ist es möglich die Leistung über einen Tastgrad (Ansteuergrad oder Duty Cycle) einer Pulsweitenmodulation zu variieren. Durch die steilen Flanken des pulsweitenmodulierten Signals ergeben sich hochfrequente Störsignale, die abgeschirmt werden müssen. Insbesondere muss dafür Sorge getragen werden, dass die hochfrequenten Störsignale nicht die ordnungsgemäße Funktion anderer elektronischer Bauteile und Komponenten im Kraftfahrzeug beeinträchtigt. Zur Abschirmung ist es bekannt, die Schaltung des Steuergeräts zur Ansteuerung der LEDs der Beleuchtungseinrichtung in einem Steuergerätegehäuse anzuordnen, das aus Metall, vorzugsweise aus Aluminiumdruckguss, besteht.

Ausgehend von dem beschriebenen Stand der Technik liegt der vorliegenden Erfindung die Aufgabe zugrunde, die Abschirmung von durch den Betrieb und die Ansteuerung von Halbleiterlichtquellen entstehenden Störsignalen auf einfache und kostengünstige Weise zu verbessern.

Zur Lösung dieser Aufgabe wird ausgehend von dem Lichtmodul der eingangs genannten Art vorgeschlagen, dass das Lichtmodul aufweist:

- eine metallische Grundfläche,

- mindestens eine auf der metallischen Grundfläche ausgebildete elektrische Isolationsschicht,
- mindestens eine in der mindestens einen elektrischen Isolationsschicht ausgebildete Aussparung, und
- die in der mindestens einen Aussparung angeordnete mindestens eine Halbleiterlichtquelle.

Die mindestens eine Halbleiterlichtquelle kann als eine Leuchtdiode (Light Emitting Diode, LED), als eine Laserdiode (Vertical Cavity Surface Emitting Laser, VCSEL) oder in beliebig anderer Weise ausgebildet sein. Eine oder mehrere LEDs sind vorzugsweise Bestandteil eines LED-Submounts. Die metallische Grundfläche bildet die Basis. Sie dient zur elektromagnetischen Abschirmung und ist mit mindestens einer elektrisch isolierenden Isolationsschicht beschichtet. In der elektrischen Isolationsschicht ist mindestens eine Aussparung ausgebildet, in der die mindestens eine Halbleiterlichtquelle beziehungsweise die LED-Chips angeordnet sind. Die in der oder den Isolationsschichten ausgebildeten Aussparungen sind etwas größer als die mindestens eine Halbleiterlichtquelle beziehungsweise die LED-Chips. In diese Aussparung werden die Halbleiterlichtquellen, die LED-Chips beziehungsweise eine die LED tragende Isolationsschicht (zum Beispiel aus Keramik) auf die metallische Grundplatte aufgebracht. Dies kann beispielsweise durch Löten, Kleben, eutektisches Bonden oder durch einen Sinterprozess erfolgen. Das eutektische Bonden dient zur Verbindung zweier Substrate, die mit einer Zwischenschicht ein eutektisches System bilden. Dieses Verfahren beruht auf der Vermischung zweier Materialien unter Ausnutzung spezieller Eigenschaften der Einzelstoffe sowie der Legierungsgemische. So bilden zum Beispiel Gold und Silizium eine Legierung, deren Schmelzpunkt bei 363°C weit niedriger als die Schmelzpunkte der Einzelstoffe liegt. Während des Bondens bildet sich bei Temperaturen größer der eutektischen Temperatur eine Legierung (Flüssigphase) an der Grenzfläche aus, die diffusionsbedingt eine starke Verbindung im atomaren Bereich bewirkt. Neben der Au-Si-Legierung werden auch eutektische Bondverfahren mit Al-Si oder Al-Ge beziehungsweise auch Systeme wie Au-In, Cu-Sn und Au-Sn unter Ausnutzung der Flüssig-Festphasen-Diffusion eingesetzt.

Im Gegensatz dazu stellt das Thermokompressionsbonden im angewandten Sinn eine Kombination eines direkten Bondverfahrens ohne Zwischenschichten dar, wobei metallische Materialien an den Grenzflächen eine wichtige Funktion (Interdiffusion) übernehmen. Verwendet werden hauptsächlich Materialien wie Cu, Au, Ti, die auf einen oder auch beide Bondpartner abgeschieden werden. Eine Verbindungsbildung kommt durch atomaren Kontakt, Diffusion und unter Beaufschlagung von Temperatur und Druck zustande. Zur elektrischen Kontaktierung muss vor dem Bonden ein gebildetes Oxid auf den Oberflächen sicher entfernt werden.

Durch die Verwendung der metallischen Grundflächen als Basis ist eine verbesserte elektromagnetische Verträglichkeit gegeben, da Störsignale, die durch die Ansteuerung und den Betrieb der Halbleiterlichtquellen entstehen, besonders wirksam abgeschirmt werden. Je nachdem in welchem Frequenzbereich die abzuschirmenden Störfrequenzen liegen, ergeben sich je nach Art des verwendeten Metalls unterschiedliche Eindringtiefen $\delta = \sqrt{2/\omega\sigma\mu}$ , mit der Kreisfrequenz $\omega$, der elektrischen Leitfähigkeit $\sigma$ und der Permeabilität $\mu$. Die Dicke beziehungsweise Stärke der metallischen Grundfläche kann dementsprechend gewählt werden, um eine gute Abschirmung der Störfrequenzen und damit eine gute elektromagnetische Verträglichkeit der Ansteuerschaltung für die Halbleiterlichtquellen zu gewährleisten.

Auf der elektrisch isolierenden Isolationsschicht können strukturierte metallische Flächen ausgebildet sein, die zur elektrischen Kontaktierung der Halbleiterlichtquellen beziehungsweise der LED-Chips eingesetzt werden können. Die Kombination metallische Flächen, elektrisch isolierende Isolationsschicht und metallische Grundfläche bildet einen Kondensator. Durch eine Variation der Größe der Kondensatorfläche sowie der Isolatordicke und des Isolatormaterials kann der Kapazitätswert verändert werden. Je nach Anwendungsfall kann so eine Kapazität kreiert werden, welche die schädigende Wirkung von bestimmten elektrostatischen Pulsen besonders gut mindert.

In gleicher Weise wie oben für die Halbleiterlichtquellen beschrieben, können auch andere Bauteile, wie zum Beispiel Transistoren, auf der metallischen Grundfläche angeordnet und befestigt werden. Die metallische Grundfläche kann auch Vertiefungen an den Stellen aufweisen, an denen eine Halbleiterlichtquelle beziehungsweise ein LED-Chip aufgebracht wird, um eine erhöhte Lichtausbeute der Halbleiterlichtquelle zu erreichen oder die Abstrahlcharakteristik zu formen.

Um eine eventuell erforderliche beziehungsweise vorteilhafte Isolierung zur metallischen Grundfläche zu bewirken, ist es auch denkbar, zwischen der metallischen Grundfläche und dem elektronischen Bauteil (zum Beispiel der LED oder dem Transistor) einen dünnen Isolator anzuordnen. Der dünne Isolator kann beispielsweise auf die metallische Grundfläche (Abschirmplatte) aufgebracht werden. Darüber hinaus ist es denkbar, einen oder mehrere großflächige Isolatoren zu verwenden, auf denen ein oder mehrere LED-Chips und/oder andere elektronische Bauteile angeordnet sind. Zusätzlich zu den großflächigen Isolatoren sind weitere Schaltungsträger, wie zum Beispiel eine FR4 Platine denkbar, die auf die metallische Abschirmplatte aufgebracht werden und die dann zum Beispiel durch ein Bonding-Verfahren mit den Schaltungsträgern verbunden werden, welche die Halbleiterlichtquellen und/oder die anderen elektronischen Bauelemente tragen.

Gemäß einer anderen vorteilhaften Weiterbildung der Erfindung wird vorgeschlagen, dass die metallische Grundfläche zur elektrischen Kontaktierung der elektronischen Bauteile (zum Beispiel der Halbleiterlichtquellen oder der Transistoren) eingesetzt werden kann. Dazu werden die elektronischen Bauteile mit verschiedenen Bereichen der metallischen Grundfläche kontaktiert. Zwischen den einzelnen Bereichen der metallischen Grundfläche sind isolierende Barrieren vorgesehen, um die Bereiche voneinander elektrisch zu isolieren. Eine solche Isolierung von Teilbereichen der metallischen Grundfläche relativ zueinander ist insbesondere dann besonders vorteilhaft, wenn die Halbleiterlichtquellen, die LED-Chips oder die anderen elektronischen Bauteile in der sogenannten Flipchip-Technologie ausgebildet sind. Dabei liegen dann die Anschlussflächen des elektronischen Bauteils unter dem Bauteil selbst, wodurch eine besonders platzsparende Kontaktierung mit den verschiedenen Abschnitten der metallischen Grundfläche möglich ist.

Auf die strukturierten metallischen Flächen ist ein Aufbringen einer weiteren isolierenden Schicht möglich. Darauf kann wiederum eine weitere metallische Schicht aufgebracht werden, die elektromagnetische Strahlung absorbiert oder auch elektrische Signale führt. Dieses Aufeinanderschichten verschiedener elektrisch isolierender und leitender Schichten ist auch wiederholt denkbar. Es kann auch zweckdienlich sein, die isolierenden Schichten mit einer Durchkontaktierung zu versehen, um EMVabschirmende leitfähige Flächen und/oder stromführende Flächen miteinander zu verbinden.

Nachfolgend werden bevorzugte Ausführungsformen der Erfindung im Detail beschrieben. Dabei sind funktionsäquivalente Bauteile oder Komponenten mit den gleichen Bezugszeichen bezeichnet. Die beschriebenen Bauteile oder Komponenten haben die angegebenen Merkmale und Vorteile jeweils auch alleine, ohne dass es der übrigen Bauteile oder Komponenten des jeweiligen Ausführungsbeispiels bedarf. Es zeigen:

Figur 1      eine erfindungsgemäße Beleuchtungseinrichtung für ein Kraftfahrzeug;

Figur 2a      eine Schnittansicht durch einen Teil eines erfindungsgemäßen Lichtmoduls;

Figur 2b      oben einen beispielhaften Verlauf eines Ansteuerbeziehungsweise Energieversorgungssignals I eines LED-Chips des Lichtmoduls aus Figur 2a sowie unten einen Verlauf einer Feldstärke H bei einer Eindringtiefe d in eine metallische Grundfläche des Lichtmoduls aus Figur 2a;

Figur 3      eine Schnittansicht durch einen Teil eines weiteren Ausführungsbeispiels eines erfindungsgemäßen Lichtmoduls;

Figur 4a      eine Schnittansicht durch einen Teil eines weiteren Ausführungsbeispiels eines erfindungsgemäßen Lichtmoduls;

Figur 4b   ein Ersatzschaltbild für den in Figur 4a gezeigten Lichtmodulausschnitt;

Figur 5a   eine Schnittansicht durch einen Teil eines weiteren Ausführungsbeispiels eines erfindungsgemäßen Lichtmoduls;

Figur 5b   eine Draufsicht auf den Teil des Lichtmoduls aus Figur 5a;

Figur 6   eine Schnittansicht durch einen Teil eines weiteren Ausführungsbeispiels eines erfindungsgemäßen Lichtmoduls;

Figur 7   eine Schnittansicht durch einen Teil eines weiteren Ausführungsbeispiels eines erfindungsgemäßen Lichtmoduls; und

Figur 8   eine perspektivische Ansicht eines weiteren Ausführungsbeispiels eines erfindungsgemäßen Lichtmoduls.

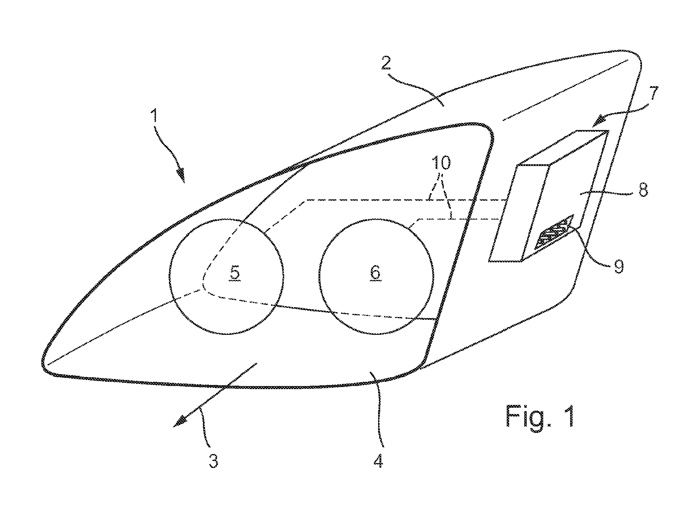

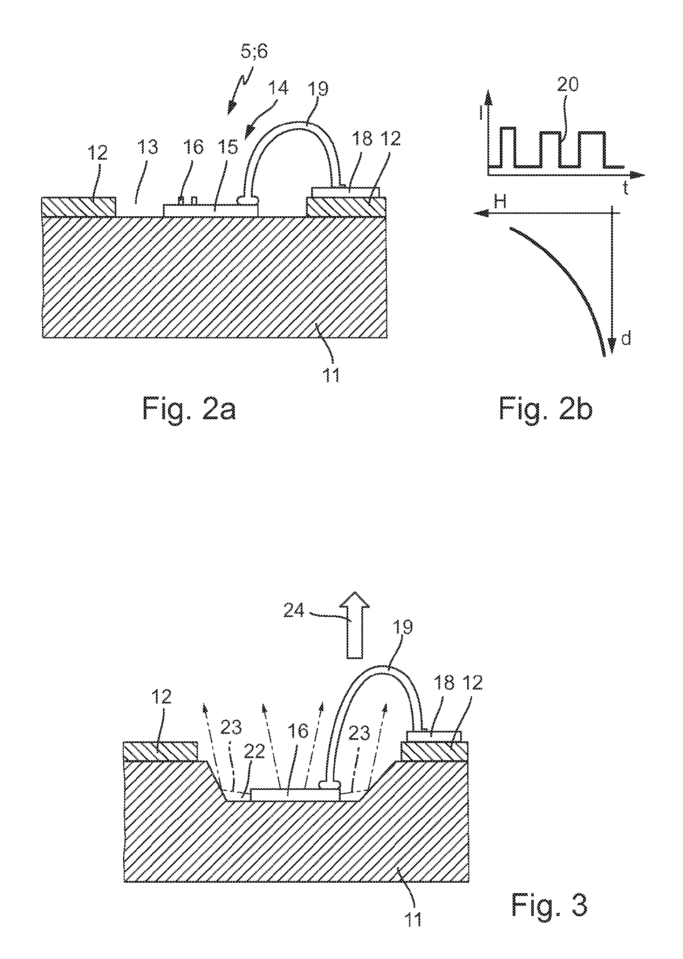

In Figur 1 ist eine erfindungsgemäße Beleuchtungseinrichtung für Kraftfahrzeuge in ihrer Gesamtheit mit dem Bezugszeichen 1 bezeichnet. Die Beleuchtungseinrichtung 1 ist in dem dargestellten Ausführungsbeispiel als ein Kraftfahrzeugscheinwerfer ausgebildet. Selbstverständlich kann die Beleuchtungseinrichtung 1 auch als eine Leuchte oder ähnliches, die am Heck oder seitlich am Kraftfahrzeug angeordnet ist, ausgebildet sein. Der Scheinwerfer 1 umfasst ein Gehäuse 2, das vorzugsweise aus Kunststoff gefertigt ist. In einer Lichtaustrittsrichtung 3 weist das Scheinwerfergehäuse 2 eine Lichtaustrittsöffnung auf, die durch eine transparente Abdeckscheibe 4 verschlossen ist. Die Abdeckscheibe 4 ist aus farblosem Kunststoff oder Glas gefertigt. Die Scheibe 4 kann ohne optisch wirksame Profile (zum Beispiel Prismen) als sogenannte klare Scheibe ausgebildet sein. Alternativ kann die Scheibe 4 zumindest bereichsweise mit optisch wirksamen Profilen, die insbesondere eine Streuung des hindurchtretenden Lichts in horizontaler Richtung bewirken, versehen sein.
Im Inneren des Scheinwerfergehäuses 2 sind in dem dargestellten Ausführungsbeispiel zwei Lichtmodule 5, 6 angeordnet. Die Lichtmodule 5, 6 sind fest oder relativ zu dem Gehäuse 2 bewegbar angeordnet. Durch eine Relativbewegung der Lichtmodule 5, 6 zum Gehäuse 2 in horizontaler Richtung kann beispielsweise eine dynamische Kurvenlichtfunktion realisiert werden. Bei einer Bewegung der Lichtmodule 5, 6 um eine horizontale Achse, also in vertikaler Richtung, kann eine Leuchtweitenregelung realisiert werden. Die Lichtmodule 5, 6 sind zur Erzeugung einer gewünschten Lichtverteilung, beispielsweise einer Abblendlicht-, einer Fernlicht-, einer Stadtlicht-, einer Landstraßen-, einer Autobahn-, einer Nebellicht-, einer statischen oder dynamischen Kurvenlicht- oder einer beliebig anderen statischen oder adaptiven Lichtverteilung ausgebildet. Die Lichtmodule 5, 6 erzeugen die gewünschte Lichtfunktion entweder alleine oder in Kombination miteinander, indem die von jedem einzelnen Lichtmodul 5; 6 gelieferten Teillichtverteilungen zu der gewünschten Gesamtlichtverteilung überlagert werden. Die Lichtmodule 5, 6 können als Reflexionsmodule und/oder als Projektionsmodule ausgebildet sein. Selbstverständlich können in dem Scheinwerfergehäuse 2 auch mehr oder weniger als die dargestellten zwei Lichtmodule 5, 6 vorgesehen sein.
An der Außenseite des Scheinwerfergehäuses 2 ist ein Steuergerät 7 in einem Steuergerätegehäuse 8 angeordnet. Das Steuergerät 7 dient zur Steuerung und/oder Regelung der Lichtmodule 5, 6 beziehungsweise von Teilkomponenten der Lichtmodule 5, 6, wie beispielsweise von Lichtquellen. Die Ansteuerung der Lichtmodule 5, 6 beziehungsweise der Teilkomponenten durch das Steuergerät 7 erfolgt über Verbindungsleitungen 10, die in Figur 1 durch eine gestrichelte Linie lediglich symbolisch dargestellt sind. Über die Leitungen 10 kann auch eine Versorgung der Lichtmodule 5, 6 mit elektrischer Energie erfolgen. Die Leitungen 10 sind durch eine Öffnung im Scheinwerfergehäuse 2 in das Steuergerätegehäuse 8 geführt und dort an die Schaltung des Steuergeräts 7 angeschlossen.
Zur besseren EMV-Abschirmung besteht das Steuergerätegehäuse 8 aus einem elektrisch leitfähigen Material, insbesondere aus Metall, vorzugsweise aus Aluminiumdruckguss. Ebenfalls zur besseren EMV-Abschirmung sind die Leitungen 10 abgeschirmt, insbesondere mittels eines die Leitungen 10 umgebenden Metallgeflechts oder eines Metall-/ Kunststoffgeflechts. In dem Steuergerätegehäuse 8 ist des weiteren eine Öffnung vorgesehen, in der ein Stecker- oder Buchsenelement 9 angeordnet ist. Über das Stecker-/ Buchsenelement 9 ist das Steuergerät 7 mit einem übergeordneten Steuergerät (z.B. mit einem sogenannten Body Controller) und/oder einer Energieversorgung des Kraftfahrzeugs (zum Beispiel einer Fahrzeugbatterie) verbunden. Die Verbindung des Steuergeräts 7 erfolgt über ein Buchsen-/Steckerelement, das in das Stecker-/Buchsenelement 9 eingeführt und mit diesem kontaktiert ist, und eine oder mehrere elektrische Leitungen.
Die Lichtmodule 5, 6 nutzen als Lichtquellen eine oder mehrere Halbleiterlichtquellen, insbesondere Leuchtdioden (LEDs). In Zukunft werden LED-Scheinwerfer 1 Einsatz finden, die eine Vielzahl einzelner LEDs aufweisen, die mehrdimensional im Scheinwerfergehäuse 2 angeordnet sind. Durch Aus- und Einschalten einzelner LEDs können variable Lichtverteilungen erzielt werden. Derartige Scheinwerfer 1 werden als Pixel- oder Matrixscheinwerfer bezeichnet. Durch diese Anhäufung mehrerer LEDs im Scheinwerfergehäuse 2 ergeben sich neue Herausforderungen bei dem Aufbau und der Ansteuerung der LEDs. Um die Leistung eines einzelnen LED-Chips zu steuern, wird dies nicht nur über die Höhe des Stroms, sondern auch über den Tastgrad (sogenannten Duty Cycle) einer Pulsweitenmodulation ermöglicht. Aufgrund der steilen Flanken des Pulssignals ergeben sich in den Lichtmodulen 5, 6 hochfrequente Anteile, die abgeschirmt werden müssen. Zur besseren Abschirmung von hochfrequenten Störsignalanteilen und damit zur besseren EMV-Verträglichkeit des LED-Scheinwerfers 1 werden verschiedene Ausgestaltungsformen eines erfindungsgemäßen Lichtmoduls 5, 6 in den Figuren 2a bis 8 dargestellt und nachfolgend beschrieben. Die Beleuchtungseinrichtung 1 aus Figur 1 hat mindestens ein Lichtmodul 5, 6, das als ein erfindungsgemäßes Lichtmodul gemäß der Figuren 2a bis 8 ausgestaltet ist.

In Figur 2a ist ein erstes Ausführungsbeispiel eines erfindungsgemäßen Lichtmoduls 5; 6 im Ausschnitt gezeigt. Das Lichtmodul 5; 6 umfasst eine metallische Grundfläche 11, die eine Basis bildet und zur elektromagnetischen Abschirmung dient. Die Grundfläche 11 ist mit einer elektrisch isolierenden Schicht 12 beschichtet. Die elektrische Isolationsschicht 12 verfügt über eine Aussparung 13, in der eine Halbleiterlichtquelle 14 zum Beispiel in Form eines LED-Chips 16 oder eines LED-Submounts 14 angeordnet ist. Ein LED-Submount 14 kann eine oder mehrere LED-Chips 16 aufweisen.

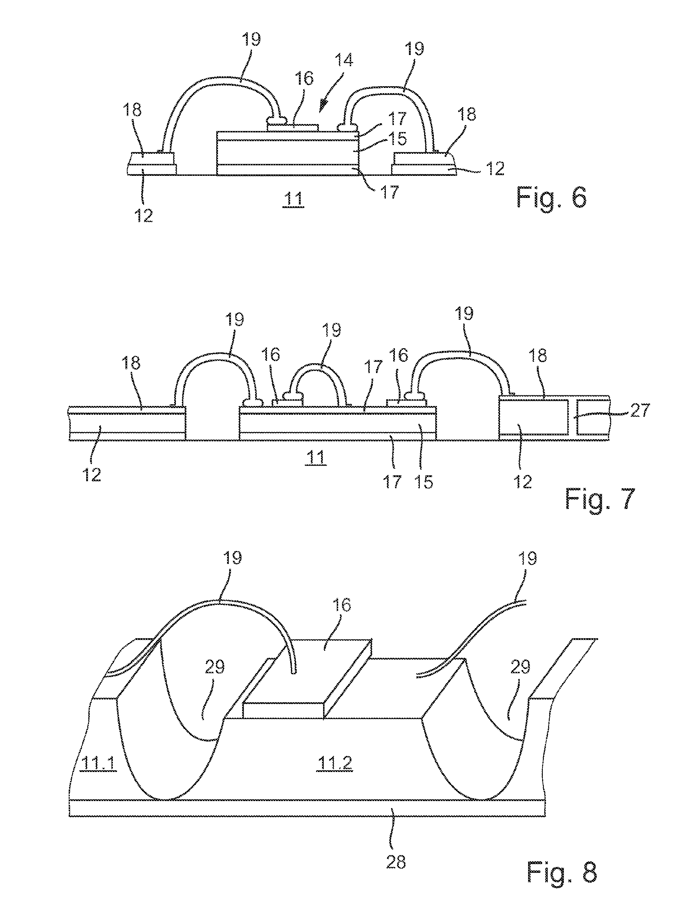

Das LED-Submount 14 umfasst eine Trägerschicht 15, die beispielsweise aus A1N (Aluminiumnitrid)-Keramik besteht, auf der die LEDs 16 zum Beispiel durch Löten, Kleben, eutektisches Bonden oder durch einen Sinterprozess aufgebracht sind. Das Isoliermaterial der Trägerschicht 15 kann beidseitig mit Metall 17 (vergleiche Figur 6), zum Beispiel Kupfer (Cu), Molybdän (Mo) oder Wolfram (W), beschichtet sein, wobei die LEDs 16 dann auf die Metallschicht 17 aufgebracht sind. Verschiedene Metalle 11, 17 ermöglichen einen angepassten Ausdehnungskoeffizienten, und/oder eine veränderbare Temperaturbeständigkeit. In den isolierenden Schichten 12 sind die Aussparungen 13 etwas größer ausgebildet als der darin angeordnete LED-Chip 16 beziehungsweise die die LEDs 16 tragende Keramik 15. Das LED-Submount 14 beziehungsweise die die LEDs 16 tragende Keramik 15 wird auf die Metallplatte 11 aufgebracht. Dies kann beispielsweise durch Löten, Kleben oder eutektisches Bonden oder durch ein Sinterprozess erfolgen.

Auf dem isolierenden Material 12 können strukturierte metallische Leiterflächen 18 ausgebildet sein, die zur elektrischen Verbindung und Kontaktierung der LEDs 16 beziehungsweise der LED-Submounts 14 herangezogen werden können. Der LED-Chip 16 beziehungsweise die LEDs können mittels Bonden mit den strukturierten metallischen Leiterflächen 18 verbunden werden. Die entsprechenden Bondingdrähte sind in den Figuren mit dem Bezugszeichen 19 bezeichnet.

Durch die metallische Grundfläche 11 ist eine deutlich verbesserte elektromagnetische Verträglichkeit des Lichtmoduls 5, 6 gegeben. Je nachdem in welchem Frequenzbereich die abzuschirmenden Frequenzen liegen, ergeben sich in Abhängigkeit von dem verwendeten Material der metallischen Grundfläche 11 unterschiedliche Eindringtiefen $\delta = \sqrt{2/\omega\sigma\mu}$ , mit der Kreisfrequenz $\omega$, der elektrischen Leitfähigkeit $\sigma$ und der Permeabilität $\mu$. Durch die Wahl einer geeigneten Dicke des Materials der metallischen Grundfläche 12 kann die Eindringtiefe $\delta$ eingestellt und der Grad der Schwächung der elektromagnetischen Störsignale definiert werden.

In Figur 2b ist oben ein pulsweitenmoduliertes Ansteuersignal I (Bezugszeichen 20) für den Betrieb der LEDs 16 über der Zeit t beispielhaft aufgetragen. Das Ansteuersignal 20 ist näherungsweise als ein Rechtecksignal ausgebildet und führt aufgrund der steilen Flanken zu hochfrequenten Signalanteilen, die zu Störungen in benachbarten elektrischen Komponenten führen können und durch die metallische Grundfläche 11 abgeschirmt werden sollen. In Figur 2b unten ist die elektrische Feldstärke H über der Dicke d der metallischen Grundfläche 11 aufgetragen. Die hochfrequenten Anteile des Ansteuersignals 20 führen in der metallischen Grundfläche 11 zu Störsignalen, deren elektrische Feldstärke H unmittelbar an der Oberfläche bis zur Unterseite der Grundfläche 11 deutlich abnimmt. Die Abnahme der elektrischen Feldstärke H mit zunehmender Eindringtiefe d in die metallische Grundfläche 11 verläuft tendenziell exponentiell.

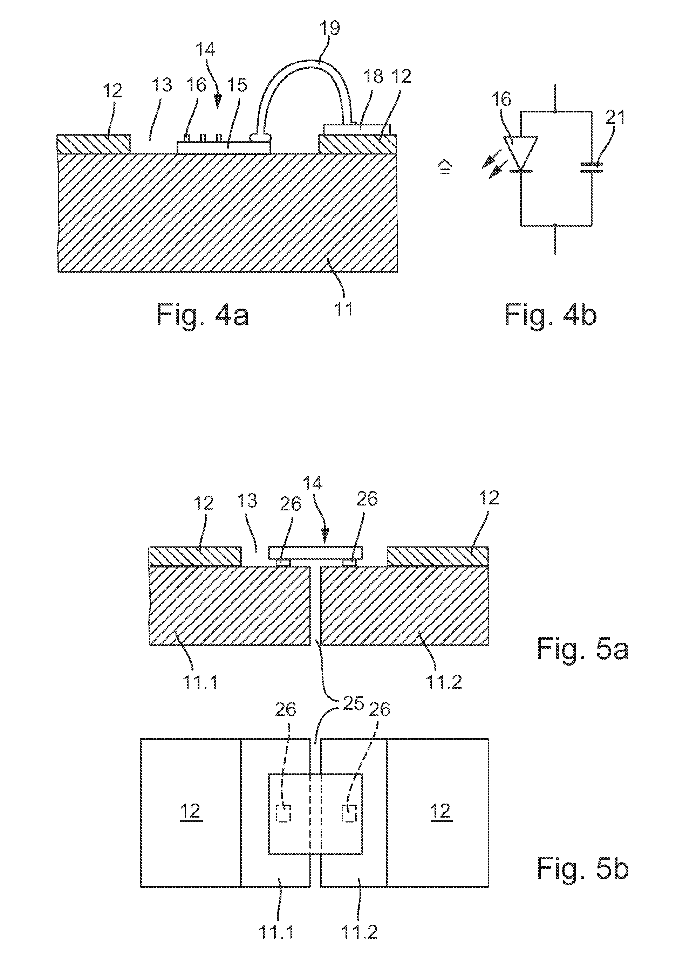

Des weiteren kann die Kombination metallische Leiterfläche 18, Isolationsschicht 12 und metallische Grundfläche 11 einen Kondensator 21 bilden (vergleiche das Ersatzschaltbild in Figur 4b), die parallel zur Leuchtdiode 16 angeordnet ist. Durch Variation der Größe der metallischen Leiterfläche 18 sowie der Dicke (beziehungsweise Stärke) und Art des Isolatormaterials 12 kann die Größe der resultierenden Kapazität auf einen gewünschten Wert eingestellt werden. Je nach Anwendungsfall kann so eine Kapazität 21 kreiert werden, welche die schädigende Wirkung von bestimmten elektrostatischen Pulsen besonders gut mindert.

In gleicher Weise wie oben erwähnt, können statt LEDs beziehungsweise LED-Chips 16, auch andere elektronische Bauteile, wie zum Beispiel Transistoren, auf der metallischen Grundfläche 11 angebracht werden. Des weiteren ist es denkbar, dass die metallische Grundfläche 11 selbst Vertiefungen 22 (vergleiche Figur 3) an den Stellen aufweist, an denen eine Leuchtdiode oder ein LED-Chip 16 aufgebracht wird, um eine erhöhte Lichtausbeute der LED 16 zu erreichen. Wie man anhand der Figur 3 gut erkennen kann, bilden schräge Seitenwände der Vertiefung 22 Reflexionsflächen, welche die von der LED 16 seitlich ausgesandten Lichtstrahlen 23 im Wesentlichen in eine Lichtaustrittsrichtung 24 des Lichtmoduls 5; 6 reflektieren. Auf diese Weise können praktisch alle von der LED 16 ausgesandten Lichtstrahlen 23 zur Erzeugung einer gewünschten Lichtverteilung beitragen.

Um eine eventuell gewünschte Isolierung des elektronischen Bauteils zur metallischen Grundfläche 11 zu ermöglichen, ist es denkbar, dass zwischen der metallischen Grundfläche 11 und dem Bauteil, beispielsweise der LED 16 oder einem Transistor, ein dünner Isolator vorgesehen ist. Darüber hinaus kann auch mindestens ein großflächiger Isolator 15 eingesetzt werden, auf den ein oder mehrere LED-Chips 16 und/oder andere elektronische Bauteile aufgebracht sind. Diese Isolatoren können dann auf die EMV-Abschirmplatte 11 aufgebracht werden. Zusätzlich zu diesen sind weitere Schaltungsträger, wie zum Beispiel eine FR4 Platine denkbar, die auf die EMV-Abschirmplatte 11 aufgebracht werden und die dann zum Beispiel durch Bonding-Verbindungen 19 mit den Schaltungsträgern 15 verbunden werden, welche die LEDs 16 und/oder die anderen Bauelemente tragen.

Die metallische Grundfläche 11 kann zur elektrischen Anbindung der elektronischen Bauteile beitragen (vergleiche Figur 5a und Figur 5b). In diesem Fall sind vorzugsweise isolierende Barrieren 25 in der metallischen Grundfläche 11 ausgebildet, durch welche die Grundfläche 11 in mehrere, zueinander elektrisch isolierte Abschnitte 11.1, 11.2, ... unterteilt wird. Die Abschnitte 11.1 und 11.2 liegen vorzugsweise auf unterschiedlichen Potenzialen. Eine solche Anbindung der LED-Chips 16 beziehungsweise der LEDs ist insbesondere dann vorteilhaft, wenn die LED-Chips 16 beziehungsweise die LEDs oder die anderen elektronischen Bauteile in der Flipchip-Technologie ausgebildet sind. Dabei liegen Anschluss- beziehungsweise Kontaktflächen 26 unter dem Bauteil 14, 16. Mit diesen nach unten gerichteten Anschluss- beziehungsweise Kontaktflächen 26 wird das Bauteil 14, 16 mit den verschiedenen Abschnitten 11.1, 11.2, ... der metallischen Grundfläche 11 kontaktiert.

Es ist denkbar, auf die strukturierten metallischen Flächen 18 weitere isolierende Flächen aufzubringen (in den Figuren nicht dargestellt). Darauf kann wiederum eine weitere metallische Schicht aufgetragen werden, die elektromagnetische Strahlung absorbiert oder auch elektrische Signale führen kann. Dieses Aufeinanderschichten mehrerer Schichten ist auch wiederholt denkbar. In dem Ausführungsbeispiel aus Figur 7 sind die Isolationsschichten 12 als eine FR4-Platine ausgebildet. Diese ist sowohl an ihrer Oberseite als auch an ihrer Unterseite mit einem elektrisch leitfähigen Material 18, beispielsweise Kupfer, beschichtet. Außerdem sind in Figur 7 Durchkontaktierungen 27 zwischen der auf der Oberseite der Isolationsschicht 12 und der an der Unterseite der Isolationsschicht 12 ausgebildeten leitfähigen Schicht 18 ausgebildet. Dies kann zweckdienlich sein, um EMV-Flächen und/oder stromführende Flächen 18 miteinander zu verbinden.

Zusätzlich oder anstatt dieser verschiedenen Schichten kann auch eine isolierende Schicht, z.B. die Isolationsschicht 12, aufgebracht werden, die wiederum Aussparungen 13 aufweist, so dass diese mit dielektrischer Masse derart geformt ist, dass eine optimierte Strahlführung des Lichts gegeben ist. Diese Aussparungen 13 können eine oder mehrere LEDs beziehungsweise einen oder mehrere LED-Chips 16 oder ein oder mehrere andere elektronische Bauteile aufnehmen.

In dem Ausführungsbeispiel aus Figur 8 ist die metallische Grundfläche 11 auf eine Isolationsschicht 28 aufgebracht. In der dargestellten Schnittansicht sind rechts und links der LED 16 Gräben 29 ausgebildet, die sich durch die gesamte Materialdicke beziehungsweise -stärke der leitfähigen Grundfläche 11 bis zu der Isolationsschicht 28 erstrecken. Die Gräben 29 isolieren also Abschnitte 11.1, 11.2, ... der leitfähigen Grundfläche 11 voneinander.

## Patentansprüche

1. Lichtmodul (5; 6) für eine Beleuchtungseinrichtung (1) eines Kraftfahrzeugs, das Lichtmodul (5; 6) umfassend mindestens eine Halbleiterlichtquelle (16), **dadurch gekennzeichnet, dass** das Lichtmodul (5; 6) aufweist:

   - eine metallische Grundfläche (11),
   - mindestens eine auf der metallischen Grundfläche (11) ausgebildete elektrische Isolationsschicht (12),
   - mindestens eine in der mindestens einen elektrischen Isolationsschicht (12) ausgebildete Aussparung (13), und
   - die in der mindestens einen Aussparung (13) angeordnete mindestens eine Halbleiterlichtquelle (16).

2. Lichtmodul (5; 6) nach Anspruch 1, **dadurch gekennzeichnet, dass** die mindestens eine Halbleiterlichtquelle (16) Bestandteil eines Submounts (14) ist.

3. Lichtmodul (5; 6) nach Anspruch 2, **dadurch gekennzeichnet, dass** das Submount (14) eine Schicht (15) aus Isoliermaterial aufweist, auf der die mindestens eine Halbleiterlichtquelle (16) montiert und elektrisch kontaktiert ist.

4. Lichtmodul (5; 6) nach Anspruch 3, **dadurch gekennzeichnet, dass** das Isoliermaterial aus Aluminiumnitrid gefertigt ist.

5. Lichtmodul (5; 6) nach Anspruch 2 oder 3, **dadurch gekennzeichnet, dass** die Schicht (15) aus Isoliermaterial zumindest auf einer Seite mit einer elektrisch leitfähigen Schicht (17), vorzugsweise aus Metall, insbesondere aus Kupfer, Molybdän oder Wolfram, beschichtet ist.

6. Lichtmodul (5; 6) nach einem der Ansprüche 3 bis 5, **dadurch gekennzeichnet, dass** die mindestens eine Halbleiterlichtquelle (16) durch Kleben oder einen Sinterprozess auf der Schicht (15) aus Isoliermaterial befestigt ist.

7. Lichtmodul (5; 6) nach einem der Ansprüche 3 bis 6, **dadurch gekennzeichnet, dass** die mindestens eine Halbleiterlichtquelle (16) durch Löten oder eutektisches Bonden kontaktiert ist.

8. Lichtmodul (5; 6) nach einem der Ansprüche 1 bis 7, **dadurch gekennzeichnet, dass** die Abmessungen der mindestens einen Aussparung (13) größer sind als die entsprechenden Abmessungen der darin angeordneten mindestens einen Halbleiterlichtquelle (16) bzw. des darin angeordneten LED-Chips (16).

9. Lichtmodul (5; 6) nach einem der Ansprüche 1 bis 8, **dadurch gekennzeichnet, dass** die mindestens eine Halbleiterlichtquelle (16) bzw. der LED-Chip (16) durch Kleben oder einen Sinterprozess in der mindestens einen Aussparung (13) auf der metallischen Grundfläche (11) befestigt ist.

10. Lichtmodul (5; 6) nach einem der Ansprüche 1 bis 9, **dadurch gekennzeichnet, dass** die mindestens eine Halbleiterlichtquelle (16) durch Löten oder eutektisches Bonden kontaktiert ist.

11. Lichtmodul (5; 6) nach einem der Ansprüche 1 bis 10, **dadurch gekennzeichnet, dass** auf der Isolationsschicht (12) strukturierte metallische Flächen (18) zur elektrischen Energieversorgung der mindestens einen Halbleiterlichtquelle (16) bzw. des LED-Chips (16) angeordnet sind.

12. Lichtmodul (5; 6) nach Anspruch 11, **dadurch gekennzeichnet, dass** die Einheit umfassend die metallische Grundfläche (11), die Isolationsschicht (12) und die strukturierte metallische Fläche (18) eine Kapazität bildet, wobei eine Dicke und/oder Fläche der strukturierten metallischen Fläche (18) zur Generierung gewünschter kapazitiver Eigenschaften gewählt ist.

13. Lichtmodul (5; 6) nach einem der Ansprüche 1 bis 12, **dadurch gekennzeichnet, dass** die metallische Grundfläche (18) mindestens eine Vertiefung (22) an den Stellen aufweist, wo die mindestens eine Halbleiterlichtquelle (16) bzw. der LED-Chip (16) angeordnet ist.

14. Lichtmodul (5; 6) nach einem der Ansprüche 1 bis 13, **dadurch gekennzeichnet, dass** auf die metallische Grundfläche (11) ein Schaltungsträger für andere elektrische Bauteile aufgebracht ist.

15. Lichtmodul (5; 6) nach Anspruch 14, **dadurch gekennzeichnet, dass** der Schaltungsträger als eine Leiterplatte mit Materialkennung FR4 ausgebildet ist.

16. Lichtmodul (5; 6) nach einem der Ansprüche 1 bis 15, **dadurch gekennzeichnet, dass** die metallische Grundfläche (11) zur elektrischen Anbindung der mindestens einen Halbleiterlichtquelle (16) bzw. des LED-Chips (16) ausgebildet ist.

17. Lichtmodul (5; 6) nach Anspruch 16, **dadurch gekennzeichnet, dass** in der metallischen Grundfläche (11) isolierende Barrieren (25) zum elektrischen Isolieren eines ersten Bereichs (11.1) der Grundfläche (11) gegenüber mindestens einem anderen Bereich (11.2) der Grundfläche (11) eingebracht sind.

18. Lichtmodul (5; 6) nach einem der Ansprüche 1 bis 17, **dadurch gekennzeichnet, dass** die mindestens eine Haltleiterlichtquelle (16) bzw. der LED-Chip (16) mittels der Flip-Chip-Technik auf der metallischen Grundfläche (11) kontaktiert ist.

19. Beleuchtungseinrichtung (1) eines Kraftfahrzeug, umfassend mindestens ein Lichtmodul (5, 6) nach einem der Ansprüche 1 bis 18.

Fig. 1

Fig. 2a

Fig. 2b

Fig. 3

Fig. 4a

Fig. 4b

Fig. 5a

Fig. 5b

Fig. 6

Fig. 7

Fig. 8